# DEMANDE DE BREVET EUROPEEN

(11) **EP 1 137 062 A1**
(43) Date de publication de la demande: **26.09.2001**
(21) Numéro de dépôt: 01201018.7
(22) Date de dépôt: 19.03.2001
(51) Int. Cl.: H01L 21/762, H01L 21/3105, H01L 21/311

(54) **Procédé de formation de zone isolante**

(30) Priorité: 24.03.2000 FR 0003793
(71) Demandeur: Koninklijke Philips Electronics N.V., 5621 BA Eindhoven (NL); STMicroelectronics SA, 94250 Gentilly Cedex (FR)
(72) Inventeur: Inard, Alain, 75008 Paris (FR); Zulian, Dominique, 75008 Paris (FR); Levy, Didier, 75008 Paris (FR); Lunenborg, Meindert, 75008 Paris (FR); De Coster, Walter, 75008 Paris (FR); Oberlin, Jean-Claude, 75008 Paris (FR)
(74) Mandataire: Lottin, Claudine

(57) **Abrégé**

L'invention concerne un procédé de formation, dans un substrat semiconducteur (10), d'une zone isolante (14) entourant une zone active (12), comprenant les étapes suivantes :
a) former, dans le substrat, une tranchée entourant une zone active (12) ;
b) remplir la tranchée d'un premier matériau de façon à réaliser, autour de la zone active, une zone isolante (14) dépassant de la surface du substrat et formant un rebord vertical à sa périphérie ; et
c) émousser, en périphérie de la zone active, l'angle présenté par le rebord de la zone isolante.

L'invention concerne également un dispositif semiconducteur réalisé en utilisant cette méthode.

## Description

La présente invention concerne, de façon générale, un procédé de formation d'une zone isolante entourant une zone active d'un substrat semiconducteur.

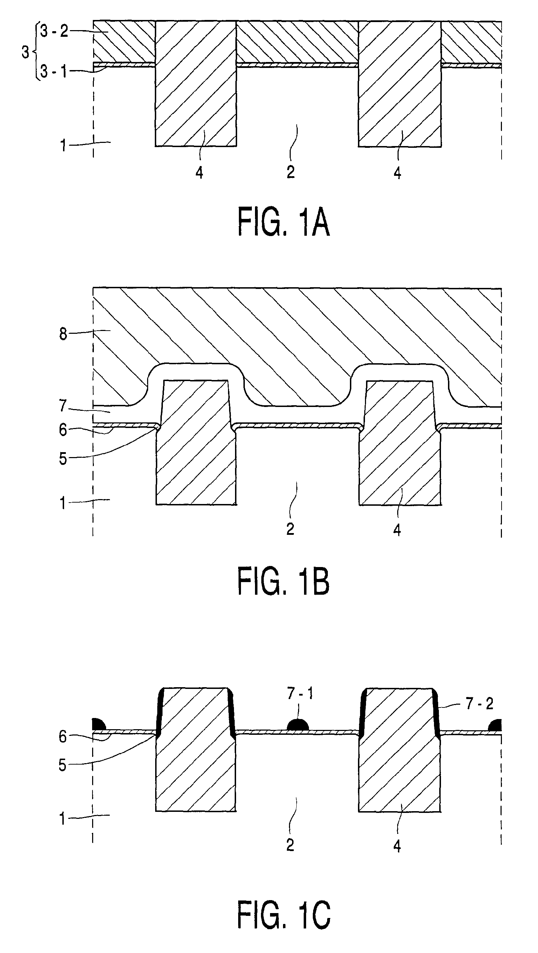

Les figures 1A, 1B et 1C sont des vues en coupe partielle et schématique illustrant à titre d'exemple, un procédé classique de formation d'une zone isolante délimitant une zone active sur laquelle doit être formée une grille de commande d'un transistor de type MOS.

Comme l'illustre la figure 1A, le procédé commence par la formation dans un substrat semiconducteur 1 d'une tranchée délimitant une zone active 2. L'opération de creusement du substrat 1 pour délimiter la zone active 2 est effectuée en protégeant à l'aide d'un masque isolant 3 les parties non creusées du substrat 1. Ce masque 3 est constitué d'un bicouche comprenant une couche mince inférieure 3-1, directement en contact avec le substrat, typiquement en oxyde de silicium (SiO₂), sous-jacente à une couche épaisse 3-2 de nitrure de silicium (Si₃N₄). La tranchée est remplie d'un matériau isolant d'où il résulte la formation d'une zone isolante 4. Le remplissage de la tranchée s'effectue en deux étapes : la formation d'un oxyde thermique au fond et sur les parois de la tranchée puis un remplissage d'oxyde de silicium. Pour effectuer ce remplissage, on procède à un dépôt puis à une planarisation jusqu'au niveau de la surface supérieure du masque 3.

Aux étapes suivantes, illustrées à la figure 1B, on élimine le masque 3, et on réalise diverses étapes notamment de nettoyage. Une conséquence du retrait du masque est que la zone isolante 4 présente un rebord dépassant de la surface de la zone active 2, le rebord présentant un profil sensiblement rectiligne et vertical. Pendant les étapes de nettoyage, il peut se former, à la base du rebord une dépression 5 à la périphérie de la zone active 2.

La surface de la zone active 2 est ensuite recouverte d'une couche mince isolante 6. À ce stade, sont généralement mises en oeuvre des séquences de dopage de la zone active 2 par implantation/diffusion. De telles opérations sont ici ignorées car elles n'ont aucune incidence sur les problèmes exposés ci-après. La couche 6 est par exemple destinée à constituer l'isolant de grille d'un transistor MOS. Après la formation de cet isolant de grille 6, on dépose une couche 7 d'un matériau conducteur, généralement du silicium polycristallin. Afin de définir une grille d'une structure de type transistor, on dépose alors dans l'exemple illustré une couche épaisse 8 d'un matériau de revêtement anti-réflecteur, généralement désigné par l'acronyme anglo-saxon Barc (Bottom Antireflective Coating), puis un masque de résine définissant le motif de la grille à former (une autre façon de procéder serait de déposer d'abord le masque de résine puis le matériau anti-réflecteur). La couche de résine n'est pas représentée à la figure 1B, car on suppose que la coupe est effectuée dans une région de la zone active 2 où la grille ne passe pas. Il est connu d'utiliser typiquement une couche 8 de type organique qui permet d'obtenir une bonne planarisation de la structure, et qui s'élimine facilement. Toutefois, la sélectivité de gravure de la couche 8 par rapport à la résine superposée est faible.

Aux étapes suivantes, illustrées à la figure 1C, on effectue des étapes classiques de gravure afin d'éliminer la couche 7 en dehors des régions de grille et autres régions où doivent être formées des structures conductrices.

Un inconvénient de ce type de procédé réside en ce que, comme l'illustre la figure 1C, après les étapes d'élimination de la couche 7, la structure est souvent polluée par des résidus de cette couche. Plus particulièrement, il peut demeurer des résidus 7-1 sur l'isolant 6, sensiblement au centre de la zone active 2 ainsi que des résidus 7-2 le long du rebord de la zone isolante 4.

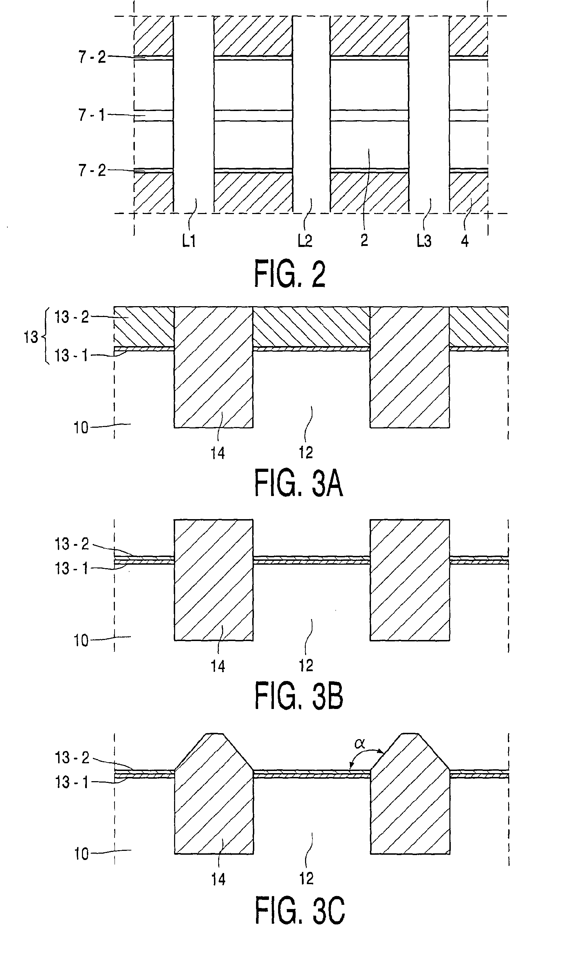

Comme cela est illustré dans la vue de dessus partielle et schématique de la figure 2, les résidus 7-1 et 7-2 provoquent, s'ils forment des pistes continues, la mise en court-circuit des structures conductrices formées sur la zone active 2 délimitée par la zone isolante 4. Par exemple, les résidus conducteurs 7-1, 7-2 provoqueront la mise en court-circuit de trois lignes conductrices L1, L2 et L3 traversant la zone active 2 et isolées de celle-ci par une couche isolante.

Une telle mise en court-circuit dans le cas de grilles de commande de transistors provoque des dysfonctionnements du dispositif dont ils font partie. Ainsi, dans le cas de matrices mémoire de type à accès aléatoire dynamique (DRAM), de telles commutations peuvent provoquer la mémorisation ou l'effacement involontaire de données.

La présente invention vise donc à proposer un nouveau procédé de fabrication qui permette de s'affranchir de la formation de résidus parasites lors de la gravure de la couche conductrice de grille.

Pour atteindre cet objet, la présente invention prévoit un procédé de formation, dans un substrat semiconducteur, d'une zone isolante entourant une zone active, comprenant les étapes suivantes :
a) former, dans le substrat, une tranchée entourant une zone active ;
b) remplir la tranchée d'un premier matériau de façon à réaliser, autour de la zone active, une zone isolante dépassant de la surface du substrat et formant un rebord vertical à sa périphérie ; et
c) émousser, en périphérie de la zone active, l'angle présenté par le rebord de la zone isolante.

Selon un mode de réalisation de la présente invention, l'étape a) de formation de la tranchée est effectuée à l'aide d'un masque constitué d'au moins un deuxième matériau.

Selon un mode de réalisation de la présente invention, l'étape c) d'émoussement de l'angle comprend les étapes suivantes :
graver le masque de façon à en laisser subsister une épaisseur réduite ; et
effectuer un bombardement à l'aide de particules.

Selon un mode de réalisation de la présente invention, l'étape c) d'émoussement de l'angle consiste à effectuer une attaque simultanée des premier et deuxième matériaux, l'attaque présentant un rapport de sélectivité entre les deuxième et premier matériaux supérieur à un.

Selon un mode de réalisation de la présente invention, l'étape c) d'émoussement de l'angle consiste à attaquer séquentiellement de faibles épaisseurs des premier et deuxième matériaux de façon à éliminer totalement le deuxième matériau et à donner au rebord un angle de l'ordre de 135 degrés par rapport à la surface du substrat.

Selon un mode de réalisation de la présente invention, le premier matériau est de l'oxyde de silicium (SiO₂) et le deuxième matériau est du nitrure de silicium (Si₃N₄).

Selon un mode de réalisation de la présente invention, les particules sont des atomes d'argon.

Selon un mode de réalisation de la présente invention, l'attaque est faite par un mélange d'acide fluorhydrique (HF) et d'éthylèneglycol (CH₂OH-CH₂OH).

Selon un mode de réalisation de la présente invention, on utilise séquentiellement une solution d'acide fluorhydrique (HF) pour attaquer le premier matériau et une solution d'acide phosphorique (H₃PO₄) pour attaquer le deuxième matériau.

Ces objets, caractéristiques et avantages, ainsi que d'autres de la présente invention seront exposés en détail dans la description suivante de modes de mise en oeuvre particuliers faite à titre non-limitatif en relation avec les figures jointes parmi lesquelles :
les figures 1A à 1C illustrent, en vue en coupe, un procédé de formation classique d'une zone isolante ;
la figure 2 illustre en vue de dessus la structure de la figure 1C ;
les figures 3A à 3E illustrent un premier mode de mise en oeuvre de la présente invention ;
les figures 4A à 4C illustrent un deuxième mode de mise en oeuvre de la présente invention ; et
la figure 5 illustre un troisième mode de mise en oeuvre de la présente invention.

Par souci de clarté, les mêmes éléments ont été désignés par les mêmes références aux différentes figures et, de plus, comme cela est habituel dans la représentation des circuits intégrés, les diverses figures ne sont pas tracées à l'échelle.

La présente invention tire avantageusement partie des recherches effectuées par les présents inventeurs sur les origines des résidus de gravure 7-1 et 7-2 (figure 1C) de la couche conductrice de grille 7 (figure 1B). Les inventeurs sont arrivés à la conclusion que de tels résidus ont une origine commune dans la topologie sensiblement verticale du rebord de la zone isolante 4 dépassant de la surface de la zone active 2.

Cette topologie sensiblement verticale complique la gravure des différents matériaux. En effet, la largeur de l'ouverture formée lors de la définition des grilles de transistors est relativement réduite par rapport à la hauteur du rebord de la zone isolante avoisinante, et le dépôt du matériau isolant de planarisation épais 8 (figure 1B) provoque une surépaisseur locale très importante à l'aplomb de la zone active. Il est alors complexe de l'éliminer complètement du fond de l'ouverture pratiquée pour définir les grilles de transistors. Il en résulte la formation des résidus 7-1.

Par ailleurs, la marche abrupte et importante entre la surface supérieure de la zone active 2 et la surface supérieure de la zone isolante 4 favorise, lors de la gravure du matériau conducteur destiné à constituer les grilles, la formation, à la périphérie de la zone active 12, en appui sur le rebord de la zone isolante, des résidus périphériques 7-2 de type espaceur.

Pour éviter la formation de ces résidus, la présente invention propose d'atténuer le profil vertical du rebord de la zone isolante en émoussant le coin de celle-ci.

Les figures 3A à 3E illustrent un premier mode de formation d'une zone isolante ayant un rebord non vertical selon la présente invention. Plus particulièrement, les figures 3A à 3E illustrent, en vue en coupe partielle et schématique, l'état d'un substrat semiconducteur 10 à différentes étapes d'un procédé selon la présente invention de formation d'une zone isolante entourant une zone active.

En figure 3A, le procédé selon l'invention commence par une séquence d'étapes classiques consistant, par exemple, à délimiter dans le substrat 10 une zone active 12 en creusant, dans le substrat 10, une tranchée à l'aide d'un masque 13 et à remplir la tranchée de façon à former une zone isolante 14. Le masque 13 peut être constitué de deux couches superposées : une couche mince inférieure 13-1 directement au contact avec le substrat 10, et une couche supérieure 13-2. Les deux couches 13-1 et 13-2 sont en des matériaux gravables sélectivement l'un par rapport à l'autre. La couche 13-1 est en un matériau gravable sélectivement par rapport au substrat 10. La couche 13-2 est gravable sélectivement par rapport au matériau constituant la zone isolante 14. Il s'agira par exemple, d'une couche 13-1 d'oxyde de silicium d'une épaisseur comprise entre 5 et 20 nm, typiquement de l'ordre de 7 nm, et d'une couche de nitrure de silicium d'une épaisseur comprise entre 100 et 200 nm, par exemple de 160 nm. On notera que le masque 13 peut être constitué d'une seule couche 13-2 gravable sélectivement par rapport au matériau constituant la zone isolante 14. Le remplissage de la tranchée peut être effectué par tout moyen approprié. Il consistera par exemple à faire croître au fond et sur les parois de la tranchée une couche d'oxyde thermique, puis à déposer de l'oxyde de silicium dans la tranchée jusqu'au niveau supérieur du masque 13 puis à planariser en s'arrêtant au niveau de la surface du masque 13.

A l'étape suivante, illustrée à la figure 3B, selon un premier mode de mise en oeuvre de la présente invention, on grave partiellement la couche supérieure 13-2 du masque 13. Cette élimination de la couche de masquage 13-2 se fait sur une épaisseur relativement importante qui sera définie ci-après. Comme l'illustre la figure 3B, le rebord de la zone isolante 14 dépasse alors par rapport à la surface du masque 13.

A l'étape suivante, illustrée à la figure 3C, on effectue un bombardement de la structure à l'aide de particules propres à émousser l'angle de la zone isolante 14 entre son rebord et sa surface supérieure. L'épaisseur maintenue en place de la couche 13-2 est choisie de façon à réaliser un compromis satisfaisant entre les conditions ci-après. D'une part, il faut que la couche 13-2 demeure suffisamment épaisse pour assurer la protection de la structure sous-jacente vis-à-vis des particules de bombardement. D'autre part, l'épaisseur de la couche 13-2 doit être minimisée de façon à accroître au maximum la portion découverte - et donc bombardée - du rebord de la zone isolante 14. Ces deux conditions sont relativement faciles à satisfaire car l'effet d'un bombardement sur une surface plane est bien moindre que sur une surface se trouvant dans un plan vertical. En d'autres termes, l'effet d'impact sur la zone 14 est beaucoup plus important que sur la couche 13-2.

Plus particulièrement, si la zone isolante 14 est en oxyde de silicium, les particules de bombardement seront de préférence des atomes d'argon, et l'angle de la zone isolante 14 est émoussé à 45 degrés. En d'autres termes, l'angle α entre le rebord de la zone isolante 14 et la surface supérieure du masque 13 sera de l'ordre de 135 degrés, au lieu de 90 degrés selon l'art antérieur. La topologie avant gravure est donc beaucoup plus ouverte que dans l'art antérieur et le dépôt conforme de la couche 17 provoque une moindre surépaisseur à la périphérie de la zone active. Si les particules de bombardement sont de l'argon et que la couche 13-2 est en nitrure de silicium, cette dernière sera partiellement éliminée pour en laisser subsister une épaisseur de l'ordre de 20 nm, le bombardement consommant dans ce cas une épaisseur de nitrure de silicium de l'ordre de 10 à 15 nm.

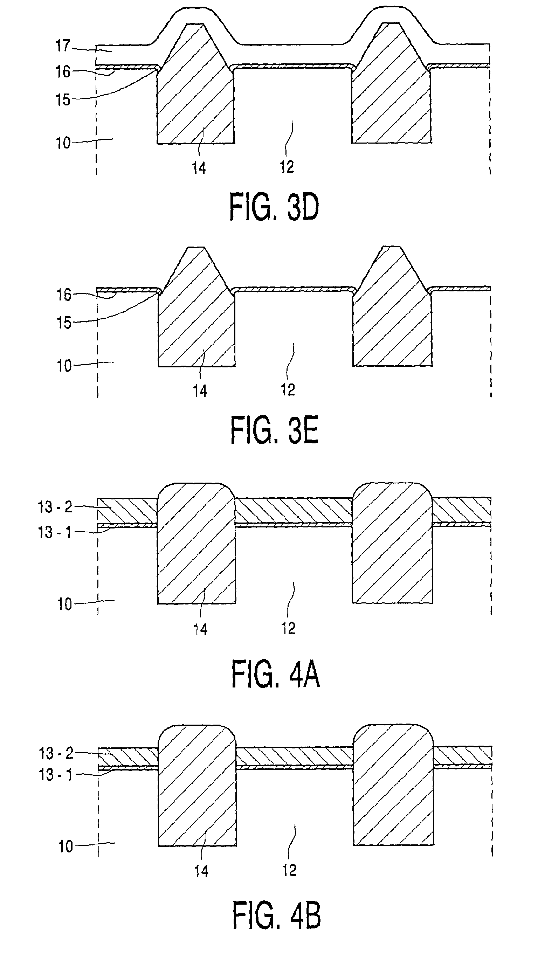

Le procédé se poursuit ensuite, comme l'illustre la figure 3D, par une séquence d'étapes comprenant par exemple les étapes suivantes : élimination du masque 13 restant ; nettoyage, pendant lequel la zone isolante 14 est attaquée, provoquant, le cas échéant, la formation d'une dépression 15 à la périphérie de la zone active 12 ; formation d'un isolant de grille 16, par de l'oxyde de silicium thermique ; et dépôt d'un matériau conducteur de grille 17. Le matériau 17 est déposé de façon conforme. Il s'agit par exemple d'une couche de silicium polycristallin d'une épaisseur de 180 à 250 nm.

On notera que la formation de l'isolant de grille 16 peut être précédée de diverses opérations, notamment de dopage de la zone active 12. L'homme de l'art comprendra que seules les étapes nécessaires à la compréhension des principes de l'invention sont incluses dans la présente description, sans effet limitatif sur ses applications possibles.

Aux étapes suivantes illustrées à la figure 3E, on effectue des opérations de dépôt du masque de gravure des structures de grille des transistors (revêtement de planarisation, résine) puis de gravure, décrites précédemment en relation avec les figures 1B et 1C. Du fait de la topologie plus ouverte de la structure selon l'invention résultant de l'émoussement de l'angle présenté par la zone isolante 14, la surépaisseur du revêtement de planarisation est moindre. Il est donc plus facilement éliminé au centre de la structure (élimination des résidus 7-1, figure 1C). De même, la surépaisseur en périphérie de la zone active de la couche 17 est relativement réduite par rapport à celle d'un procédé classique. Cela permet sa gravure totale là où elle ne doit pas subsister et aucun résidu de type espaceur n'est produit (7-2, figure 1C). Par conséquent, la structure est exempte de tout résidu du matériau conducteur 17 et l'objet de la présente invention est parfaitement rempli par ce premier mode de mise en oeuvre.

Les figures 4A à 4C illustrent, en vue en coupe schématique et partielle, un deuxième mode de mise en oeuvre de la présente invention. Ce mode de mise en oeuvre commence par les étapes décrites précédemment en relation avec les figures 1A et 3A.

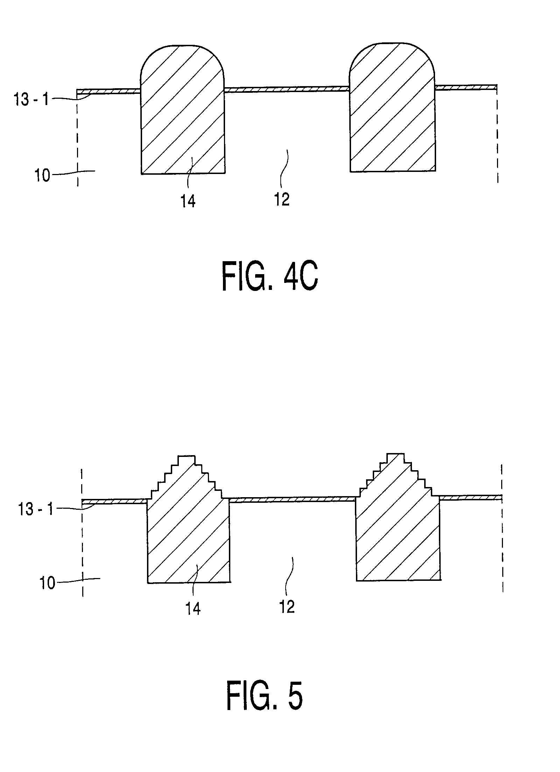

A l'étape suivante, illustrée à la figure 4A, on grave simultanément les matériaux constituant respectivement la couche supérieure 13-2 du masque 13 et la zone isolante 14. Selon la présente invention, cette gravure est effectuée à l'aide d'un agent, par exemple une solution, présentant un rapport de sélectivité entre le matériau constituant la couche 13-2 et le matériau constituant la zone isolante 14 supérieur à un. En reprenant l'exemple ci-dessus, en considérant que la couche 13-2 est en nitrure de silicium et que la zone isolante 14 est constituée d'oxyde de silicium, cela revient à utiliser un agent tel que la vitesse de gravure du nitrure de silicium soit supérieure à celle de gravure de l'oxyde de silicium. De préférence, on choisira un agent tel que le rapport des vitesses de gravure du nitrure et de l'oxyde de silicium est de l'ordre de 1,2. Par exemple, il s'agira d'une solution d'acide fluorhydrique (HF) et d'éthylèneglycol (éthanediol-1,2 CH₂OH-CH₂OH). Une telle gravure est poursuivie comme l'illustrent les figures 4B et 4C jusqu'à l'élimination totale de la couche 13-2.

La figure 4B illustre un état intermédiaire où le matériau constituant la couche 13-2 a été enlevé sensiblement à moitié (50 %) alors que le matériau constituant la zone isolante 14 n'a été que partiellement éliminé.

L'utilisation d'un agent d'une sélectivité supérieure à 1 a pour effet d'une part de consommer plus de matériau de la couche 13-2 que de matériau de la zone 14 et d'autre part d'arrondir l'angle présenté par le rebord de la zone isolante 14. La figure 4C illustre le résultat de la gravure. La couche isolante 13-2 a été complètement éliminée et l'angle du rebord de la zone isolante 14 a été émoussé, la zone isolante 14 présentant alors un profil en forme de "dôme".

Ce deuxième mode de mise en oeuvre de la présente invention permet également d'obtenir une topologie moins abrupte que celle de l'art antérieur. De même que pour le premier mode de mise en oeuvre, lors des gravures ultérieures, le matériau du revêtement anti-réflecteur et le matériau de grille (silicium polycristallin) peuvent être totalement éliminés aux endroits appropriés. Il n'y a donc plus de résidus et cela améliore la qualité des structures réalisées.

La figure 5 illustre, en vue en coupe partielle et schématique, un troisième mode de mise en oeuvre de la présente invention. La figure 5 correspond aux figures 3D/4C. Selon ce mode de mise en oeuvre, après les étapes préliminaires décrites précédemment en relation avec la figure 3A, on effectue à plusieurs reprises une gravure séquentielle de portions du matériau constituant la couche 13-2 puis de portions du matériau constituant la zone isolante 14. Il en résulte que la zone isolante 14 présente un sommet plat se terminant par un rebord en marches d'escalier.

Pour ce faire, on utilise en alternance, jusqu'à élimination complète de la couche 13-2, des agents de gravure différents propres à attaquer respectivement le matériau de la couche 13-2 et le matériau constituant la zone isolante 14. Par exemple, si ces matériaux sont respectivement du nitrure de silicium et de l'oxyde de silicium, on commencera par graver une fraction du nitrure de silicium constituant la couche 13-2 à l'aide d'acide phosphorique (H₃PO₄). On attaquera ensuite une fraction de l'oxyde de silicium constituant la zone isolante 14 à l'aide d'acide fluorhydrique (HF), et ainsi de suite. Si les attaques sont répétées de façon très rapprochées, l'aspect en marches d'escalier du rebord de la zone isolante se trouve lissé.

Dans ce troisième mode de mise en oeuvre, il convient d'arrêter la gravure de la zone isolante 14 lorsque la couche 13-2 est totalement éliminée, pour ne pas risquer de contaminer la surface de la zone active 12 par détérioration de la couche mince 13-1.

Bien entendu, la présente invention est susceptible de diverses variantes et modifications qui apparaîtront à l'homme de l'art.

En particulier, l'homme de l'art saura adapter les divers procédés d'émoussement de l'angle de la zone isolante 14 décrits précédemment au matériau la constituant. Notamment, dans le deuxième mode de réalisation, l'homme de l'art saura adapter l'agent de gravure simultanée aux matériaux gravables sélectivement l'un par rapport à l'autre constituant respectivement la couche supérieure 13-2 du masque 13 et la zone isolante 14. De plus, le rapport de sélectivité peut être ajusté en fonction de l'angle souhaité du rebord de la zone isolante 14.

Par ailleurs, on a décrit et illustré précédemment le procédé de l'invention appliqué à la formation de la grille d'un transistor de type MOS. Toutefois, l'homme de l'art notera que l'on peut former selon les mêmes principes une quelconque zone isolante délimitant, dans un substrat semiconducteur, une zone active dans laquelle doit être formé un dispositif intégré. L'homme de l'art saura également adapter les caractéristiques (matériau, épaisseur, mode de formation) des diverses couches décrites à une filière de fabrication spécifique.

## Revendications

1. Procédé de formation, dans un substrat semiconducteur (10), d'une zone isolante (14) entourant une zone active (12), comprenant les étapes suivantes :
a) former, dans ledit substrat, une tranchée entourant une zone active (12) ;
b) remplir la tranchée d'un premier matériau de façon à réaliser, autour de la zone active, une zone isolante (14) dépassant de la surface du substrat et formant un rebord vertical à sa périphérie ; et
c) émousser, en périphérie de la zone active, l'angle présenté par le rebord de la zone isolante.

2. Procédé selon la revendication 1, dans lequel l'étape a) de formation de la tranchée est effectuée à l'aide d'un masque (13) constitué d'au moins un deuxième matériau (13-2).

3. Procédé selon la revendication 2, dans lequel l'étape c) d'émoussement dudit angle comprend les étapes suivantes :
graver ledit masque (13) de façon à en laisser subsister une épaisseur réduite ; et
effectuer un bombardement à l'aide de particules.

4. Procédé selon la revendication 2, dans lequel l'étape c) d'émoussement dudit angle consiste à effectuer une attaque simultanée des premier et deuxième matériaux, ladite attaque présentant un rapport de sélectivité entre les deuxième et premier matériaux supérieur à un.

5. Procédé selon la revendication 2, dans lequel l'étape c) d'émoussement dudit angle consiste à attaquer séquentiellement de faibles épaisseurs des premier et deuxième matériaux de façon à éliminer totalement le deuxième matériau (13-2) et à donner audit rebord un angle de l'ordre de 135 degrés par rapport à la surface du substrat (10).

6. Procédé selon l'une quelconque des revendications 2 à 5, dans lequel le premier matériau est de l'oxyde de silicium (SiO₂) et le deuxième matériau (13-2) est du nitrure de silicium (Si₃N₄).

7. Procédé selon la revendication 3, dans lequel les particules sont des atomes d'argon.

8. Procédé selon les revendications 4 et 6, dans lequel ladite attaque est faite par un mélange d'acide fluorhydrique (HF) et d'éthylèneglycol (CH₂OH-CH₂OH).

9. Procédé selon les revendications 5 et 6, dans lequel on utilise séquentiellement une solution d'acide fluorhydrique (HF) pour attaquer le premier matériau et une solution d'acide phosphorique (H₃PO₄) pour attaquer le deuxième matériau (13-2).

10. Dispositif semiconducteur comprenant un substrat semiconducteur (10) et au moins une zone isolante (14) entourant une zone active (12), qui est formée en utilisant une méthode selon l'une des revendications 1 à 9.
